# EUROPEAN PATENT APPLICATION

(11) **EP 4 653 588 A1**
(43) Date of publication of application: **26.11.2025**
(21) Application number: 23917604.3
(22) Date of filing: 03.10.2023
(51) Int. Cl.: C30B 33/02, C30B 25/18, C30B 29/36, C23C 16/42

(54) **METHOD FOR MANUFACTURING 3C-SIC SINGLE-CRYSTAL EPITAXIAL SUBSTRATE, METHOD FOR MANUFACTURING 3C-SIC FREE-STANDING SUBSTRATE, AND 3C-SIC SINGLE-CRYSTAL EPITAXIAL SUBSTRATE**

(30) Priority: 19.01.2023 JP 2023006762
(71) Applicant: Shin-Etsu Handotai Co., Ltd., Tokyo 100-0004 (JP)
(72) Inventor: OHTSUKI, Tsuyoshi, Nishishirakawa-gun, Fukushima 961-8061 (JP); ABE, Tatsuo, Nishishirakawa-gun, Fukushima 961-8061 (JP); SUZUKI, Atsushi, Nishishirakawa-gun, Fukushima 961-8061 (JP); MATSUBARA, Toshiki, Nishishirakawa-gun, Fukushima 961-8061 (JP)
(74) Representative: Schicker, Silvia
(86) International application number: PCT/JP2023/035983
(87) International publication number: WO 2024/154392

(57) **Abstract**

The present invention is a method for producing a 3C-SiC single crystal epitaxial substrate, the method including: a hydrogen baking step of annealing a single crystal silicon substrate under a hydrogen atmosphere to remove a natural oxide film on a surface of the single crystal silicon substrate; an epitaxial step of performing a carbonization treatment on the surface of the single crystal silicon substrate after the hydrogen baking step to generate SiC nuclei, and epitaxially growing a 3C-SiC single crystal film using the generated nuclei as starting points to obtain a 3C-SiC single crystal epitaxial substrate; and a diffusion step of heating the 3C-SiC single crystal epitaxial substrate to a temperature lower than a melting point of Si under a gas atmosphere containing carbon to cause solid state diffusion of Si in the single crystal silicon substrate to an interface between the 3C-SiC single crystal film and the single crystal silicon substrate, and further growing the SiC by solid phase reaction between the diffused Si and incoming C at the interface, to form a vacancy layer having vacancies generated at sites from which Si has diffused, at the interface with respect to the 3C-SiC single crystal film in the single crystal silicon substrate. Thus, the present invention provides a method for producing a 3C-SiC single crystal epitaxial substrate capable of obtaining a large-diameter 3C-SiC free-standing substrate by a simple production process.

## Description

### TECHNICAL FIELD

The present invention relates to a method for producing a 3C-SiC single crystal epitaxial substrate, a method for producing a 3C-SiC free-standing substrate, and a 3C-SiC single crystal epitaxial substrate.

### BACKGROUND ART

SiC has high dielectric breakdown strength because it has a wide band gap of 2.2 to 3.3 eV, and also has high thermal conductivity, so it is expected to be used as a semiconductor material for various semiconductor devices such as power devices and high-frequency devices. In addition, SiC is known to have different crystal structures, such as 3C, 4H, and 6H, but 3C is a cubic crystal, and it is known to be a promising material that does not have orientation dependence in devices.

From such a background, 3C-SiC growth has been studied from long ago, and bulk growth (Non Patent Documents 1 and 2) and hetero-epitaxial growth (Non Patent Document 3: early hetero-epitaxial growth, Patent Documents 1 to 5: recent hetero-epitaxial growth on silicon substrates) have been known.

To summarize these previous studies/patents, (1) the bulk growth requires high temperatures (>1500°C), and it is extremely difficult to increase a diameter to a size suitable for devices, and (2) on the other hand, the epitaxial growth does not require high temperatures (>1500°C) such as in the case of 4H or 6H, and the growth is possible at a temperature of about 1100°C, so the growth on silicon substrates is also possible, which is advantageous in terms of increasing the diameter.

Based on these findings, research has been conducted on hetero-epitaxial growth of 3C-SiC on a single crystal silicon substrate and leaving only the 3C-SiC epitaxial film (Non Patent Document 4). In this method, a 2-inch 3C-SiC free-standing substrate is fabricated by growing approximately 100 µm of 3C-SiC on a Si(111) substrate and then removing the Si using fluonitric acid. This method requires an additional etching step after the growth.

In addition, a method for growing a high melting point film such as SiC on a low melting point substrate such as Si, and then melting the low melting point substrate at a high temperature, is disclosed in Patent Documents 6 and 7.

With respect to the growth of 3C-SiC, as described in Patent Document 8, it is disclosed that it is possible to grow 3C-SiC at a low temperature by growing while maintaining Si atoms in an excess of C atoms on the SiC crystal growth surface. In this case, gases are generally used as supply sources of Si and C.

### CITATION LIST

### PATENT LITERATURE

Patent Document 1: WO 2018/522412 A1
Patent Document 2: JP 2021-20819 A
Patent Document 3: JP 2006-253617 A
Patent Document 4: JP 2008-184361 A
Patent Document 5: JP 2017-39622 A
Patent Document 6: US 2013/157448 A1
Patent Document 7: US 2016/307800 A1
Patent Document 8: JP H11-162850 A

### NON PATENT LITERATURE

Non Patent Document 1: H. Nagasawa, K. Yagi and T. Kawahara," 3C-SiC hetero-epitaxial growth on undulant Si(001) substrate", Journal of Crystal Growth, 239 (2002), p1244.
Non Patent Document 2: D. Chaussende, F. Mercier, A. Boulle, F. Conchon, M. Soueidan, G. Ferro, A. Mantzari, A. Andreadou, E. K. Polychroniadis, C. Balloud, S. Juillaguet, J. Camassel and M. Pons, " Prospects for 3C-SiC bulk crystal growth" Journal of Crystal Growth, 310 (2008), p976.
Non Patent Document 3: T. Ujihara, R. Maekawa, R. Tanaka, K. Sasaki, K. Kuroda and Y. Takeda, " Solution growth of high-quality 3C-SiC crystals" Journal of Crystal Growth, 310 (2008) p1438.
Non Patent Document 4: Asamura et al., "Crystal Quality of Free-Standing 3C-SiC(111) Substrates by Low Temperature Growth", Abstracts of The 62nd Spring Meeting of the Japan Society of Applied Physics, 13-095(2015), The Japan Society of Applied Physics.

### SUMMARY OF INVENTION

### TECHNICAL PROBLEM

For methods that leave only the SiC epitaxial layer by melting the underlying Si, such as in Non Patent Document 4 and Patent Documents 6 and 7, how to handle the melted Si becomes a very big problem, and problems such as residues remaining inside the epitaxial growth apparatus can be considered. It is also easy to imagine from the vapor pressure of Si that it takes a much higher temperature and time to vaporize all the Si (1908K/1Pa) .

The present invention is made to solve the above problems, and aims to provide a method for producing a 3C-SiC single crystal epitaxial substrate capable of obtaining a large-diameter 3C-SiC free-standing substrate by a simple production process, a method for producing a 3C-SiC free-standing substrate, and a 3C-SiC single crystal epitaxial substrate capable of obtaining a large-diameter 3C-SiC free-standing substrate by a simple production process.

### SOLUTION TO PROBLEM

The present invention has been made to achieve the above object, and provides a method for producing a 3C-SiC single crystal epitaxial substrate, the method including: a hydrogen baking step of annealing a single crystal silicon substrate under a hydrogen atmosphere to remove a natural oxide film on a surface of the single crystal silicon substrate; an epitaxial step of performing a carbonization treatment on the surface of the single crystal silicon substrate after the hydrogen baking step to generate SiC nuclei, and epitaxially growing a 3C-SiC single crystal film using the generated nuclei as starting points to obtain a 3C-SiC single crystal epitaxial substrate; and a diffusion step of heating the 3C-SiC single crystal epitaxial substrate to a temperature lower than a melting point (1412±2°C: cited from "Science of Silicon" p. 919, REALIZE INC.) of Si under a gas atmosphere containing carbon to cause solid state diffusion of Si in the single crystal silicon substrate to an interface between the 3C-SiC single crystal film and the single crystal silicon substrate, and further growing the SiC by solid phase reaction between the diffused Si and incoming C at the interface, to form a vacancy layer having vacancies generated at sites from which Si has diffused, at the interface with respect to the 3C-SiC single crystal film in the single crystal silicon substrate.

According to this production method, after epitaxial growth of the 3C-SiC single crystal film on the single crystal silicon substrate, Si in the substrate is solid diffused to the interface with respect to the 3C-SiC single crystal film, to form the vacancy layer having vacancies generated at sites from which Si has diffused, at the interface while growing SiC by solid phase reaction with C, thereby allowing the 3C-SiC single crystal film to be separated from the single crystal silicon substrate by dividing along the vacancy layer by a subsequent cooling and the like.

According to this method, when obtaining a 3C-SiC free-standing substrate from the 3C-SiC single crystal epitaxial substrate in which the 3C-SiC single crystal is grown on the single crystal silicon substrate, there is no need to perform a step of raising the temperature to a high level and melting Si, which would significantly affect subsequent furnace maintenance, or to add a subsequent etching step for division.

Therefore, a large-diameter 3C-SiC free-standing substrate can be obtained by a simple production process.

At this time, the epitaxial step and the diffusion step can be performed in a pressure range of 133.322 Pa or more and 13332.2 Pa or less.

By setting the epitaxial step and the diffusion step to 133.322 Pa or more, the epitaxial step and the diffusion steps can be performed without using a special decompression device. In addition, by setting them to 13332.2 Pa or less, the epitaxial growth of 3C-SiC in the epitaxial step and the diffusion of Si in the diffusion step can be promoted.

The present invention also provides a method for producing a 3C-SiC free-standing substrate, the method including a separation step of cooling the 3C-SiC single crystal epitaxial substrate produced by the production method described above to divide the 3C-SiC single crystal epitaxial substrate along the vacancy layer, separating the 3C-SiC single crystal film from the single crystal silicon substrate, to be a 3C-SiC free-standing substrate.

According to this method, when the 3C-SiC free-standing substrate is obtained from the 3C-SiC single crystal in which the 3C-SiC single crystal is grown on a silicon substrate, the silicon substrate and the 3C-SiC single crystal can be separated simply by cooling, so that there is no need to perform a step of raising the temperature to a high level and melting Si, which would significantly affect subsequent furnace maintenance, or to add a subsequent etching step for division.

Therefore, a large-diameter 3C-SiC free-standing substrate can be obtained by a simple production process.

The present invention further provides a 3C-SiC single crystal epitaxial substrate including: a single crystal silicon substrate; and a 3C-SiC single crystal film having an epitaxial structure formed on the single crystal silicon substrate; wherein the single crystal silicon substrate includes a vacancy layer containing clusters of vacancies generated due to loss of Si at an interface with respect to the 3C-SiC single crystal film.

Since such a 3C-SiC single crystal epitaxial substrate includes the vacancy layer containing the clusters of vacancies generated due to the loss of Si at the interface with respect to the 3C-SiC single crystal film, it is possible to separate the 3C-SiC single crystal film from the single crystal silicon substrate by dividing along the vacancy layer by cooling and the like, without melting Si or etching for division.

Therefore, it is possible to obtain a large-diameter 3C-SiC free-standing substrate by a simple production process.

### ADVANTAGEOUS EFFECTS OF INVENTION

As described above, according to a method for producing a 3C-SiC single crystal epitaxial substrate of the present invention, a 3C-SiC single crystal epitaxial substrate capable of obtaining a large-diameter 3C-SiC free-standing substrate can be produced by a simple production process.

In addition, according to a method for producing of a 3C-SiC free-standing substrate of the present invention, it is possible to obtain a large-diameter 3C-SiC free-standing substrate by a simple production process.

Furthermore, according to a 3C-SiC single crystal epitaxial substrate of the present invention, it is possible to obtain a large-diameter 3C-SiC free-standing substrate by a simple production process.

### BRIEF DESCRIPTION OF DRAWINGS

FIG. 1 shows a schematic diagram of a 3C-SiC single crystal epitaxial substrate according to the embodiments of the present invention;
FIG. 2 shows a flow diagram of a method for producing a 3C-SiC single crystal epitaxial substrate and a method for producing a 3C-SiC free-standing substrate according to the embodiments of the present invention; and
FIG. 3 shows a result of In-Plane XRD analysis of the 3C-SiC single crystal epitaxial substrate obtained in Example.

### DESCRIPTION OF EMBODIMENTS

Hereinafter, the present invention will be described in detail. However, the present invention is not limited thereto.

As described above, a method for producing a 3C-SiC single crystal epitaxial substrate capable of obtaining a large-diameter 3C-SiC free-standing substrate by a simple production process, a method for producing a 3C-SiC free-standing substrate, and a 3C-SiC single crystal epitaxial substrate capable of obtaining a large-diameter 3C-SiC free-standing substrate by a simple production process have been required.

As a result of intensive studies to solve the above problem, the present inventors have found that a 3C-SiC single crystal epitaxial substrate capable of obtaining a large-diameter 3C-SiC free-standing substrate can be produced by a simple production process, according to a method for producing a 3C-SiC single crystal epitaxial substrate, the method including: a hydrogen baking step of annealing a single crystal silicon substrate under a hydrogen atmosphere to remove a natural oxide film on a surface of the single crystal silicon substrate; an epitaxial step of performing a carbonization treatment on the surface of the single crystal silicon substrate after the hydrogen baking step to generate SiC nuclei, and epitaxially growing a 3C-SiC single crystal film using the generated nuclei as starting points to obtain a 3C-SiC single crystal epitaxial substrate; and a diffusion step of heating the 3C-SiC single crystal epitaxial substrate to a temperature lower than a melting point of Si under a gas atmosphere containing carbon to cause solid state diffusion of Si in the single crystal silicon substrate to an interface between the 3C-SiC single crystal film and the single crystal silicon substrate, and further growing the SiC by solid phase reaction between the diffused Si and incoming C at the interface, to form a vacancy layer having vacancies generated at sites from which Si has diffused, at the interface with respect to the 3C-SiC single crystal film in the single crystal silicon substrate; and arrived at completing the present invention.

In addition, as a result of intensive studies to solve the above problem, the present inventors have found that a large-diameter 3C-SiC free-standing substrate can be obtained by a simple production process, according to a method for producing a 3C-SiC free-standing substrate, the method including a separation step of cooling the 3C-SiC single crystal epitaxial substrate produced by the production method described above to divide the 3C-SiC single crystal epitaxial substrate along the vacancy layer, separating the 3C-SiC single crystal film from the single crystal silicon substrate, to be a 3C-SiC free-standing substrate, and arrived at completing the present invention.

Furthermore, as a result of intensive studies to solve the above problem, the present inventors have found that a large-diameter 3C-SiC free-standing substrate can be obtained by a simple production process, according to a 3C-SiC single crystal epitaxial substrate including: a single crystal silicon substrate; and a 3C-SiC single crystal film having an epitaxial structure formed on the single crystal silicon substrate; wherein the single crystal silicon substrate includes a vacancy layer containing clusters of vacancies generated due to loss of Si at an interface with respect to the 3C-SiC single crystal film, and arrived at completing the present invention.

The following description will be given with reference to drawings.

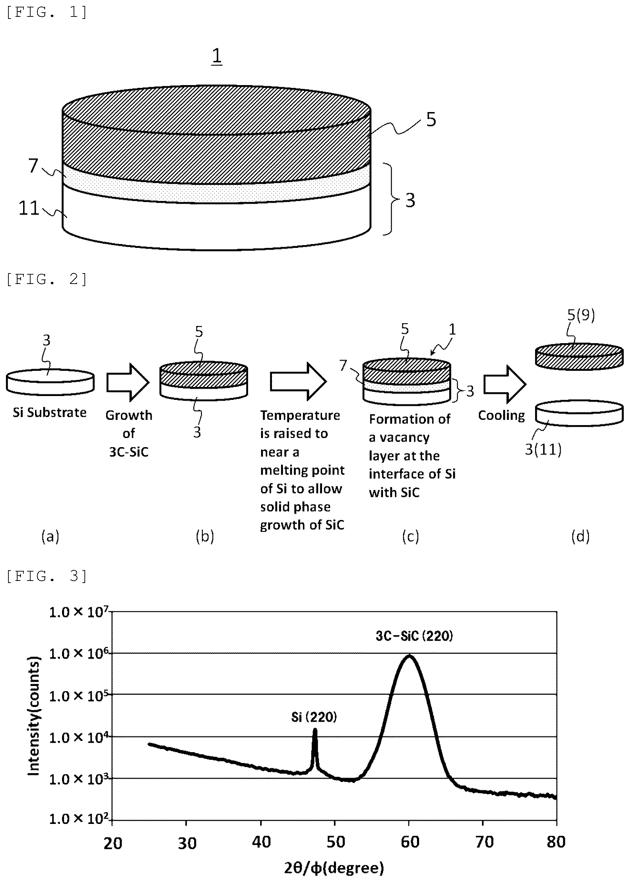

Hereinafter, with reference to FIG. 1 and FIG. 2, a method for producing a 3C-SiC single crystal epitaxial substrate 1, a method for producing a 3C-SiC free-standing substrate 9, and a structure of the 3C-SiC single crystal epitaxial substrate 1, according to the embodiments of the present invention, are described.

First, with reference to FIG. 1, a rough structure of the 3C-SiC single crystal epitaxial substrate 1 according to the embodiments of the present invention is described.

As shown in FIG. 1, the 3C-SiC single crystal epitaxial substrate 1 includes a single crystal silicon substrate 3 and a 3C-SiC single crystal film 5 having an epitaxial structure formed on the single crystal silicon substrate.

The single crystal silicon substrate 3 is a substrate to be used as a base on which the 3C-SiC single crystal film 5 is formed by epitaxial growth. A thickness of the single crystal silicon substrate 3 depends on a thickness of the 3C-SiC single crystal film 5, but it is sufficient, for example, if it is the thickness such that the single crystal silicon substrate 3 is not bent or cracked due to stress caused by, for example, the difference in lattice constants of silicon and SiC when the 3C-SiC single crystal film 5 is formed by epitaxial growth.

A diameter of the single crystal silicon substrate 3 is at least equal to or larger than a diameter of the 3C-SiC single crystal film 5, but the larger the diameter of the single crystal silicon substrate 3 is, the larger the diameter of the 3C-SiC single crystal film 5 is formed, so that the diameter is preferably 200 mm or more, and more preferably 300 mm or more.

In addition, the single crystal silicon substrate 3 has a vacancy layer 7 containing clusters of vacancies generated due to loss of Si at an interface with respect to the 3C-SiC single crystal film.

The vacancy layer 7 is brittle compared with the other part because it contains the clusters of vacancies. Therefore, by applying stress by cooling and the like, it is possible to easily separate the 3C-SiC single crystal film 5 from the single crystal silicon substrate 3 by dividing the 3C-SiC single crystal epitaxial substrate 1 along the vacancy layer 7.

Therefore, the 3C-SiC single crystal epitaxial substrate 1 is capable of obtaining a large-diameter 3C-SiC free-standing substrate by a simple production process.

In addition, the part except for the vacancy layer 7 in the single crystal silicon substrate 3 is referred to as a base 11 in the following description. Further, a density of vacancies in the vacancy layer 7 and a thickness of the vacancy layer are appropriately set in a range that the 3C-SiC single crystal epitaxial substrate 1 can be easily divided by cooling.

The 3C-SiC single crystal film 5 is a film having an epitaxial structure. A lower limit of the thickness of the 3C-SiC single crystal film 5 is, for example, such that it can maintain its shape without bending or cracking even after being separated from the single crystal silicon substrate 3, and it is not lost in polishing or etching, etc., in the subsequent device formation and the like. An upper limit of the thickness is such that it does not become too expensive due to a large amount of an unused part generated in the subsequent device formation and the like. Furthermore, the diameter of the 3C-SiC single crystal film 5 is equal to or smaller than the diameter of the single crystal silicon substrate 3.

Next, with reference to FIG. 2, the method for producing a 3C-SiC single crystal epitaxial substrate 1 and the method for producing a 3C-SiC free-standing substrate 9 according to the embodiments of the present invention are described.

First, as shown in FIG. 2(a), the single crystal silicon substrate 3 is prepared, which is a base for epitaxially growing the 3C-SiC single crystal film 5. The plane orientation of a surface of the single crystal silicon substrate 3 to be prepared is determined depending on the plane orientation of the 3C-SiC single crystal film 5 to be grown, and is, for example, (111) plane, but (110) plane or (100) plane may be possible. The thickness of the single crystal silicon substrate 3 may be selected to be thick enough so that it does not bend or crack during growth, depending on the thickness of the 3C-SiC single crystal film 5 to be grown. The diameter of the single crystal silicon substrate 3 should be equal to or larger than the diameter of the 3C-SiC single crystal film 5 to be grown.

Then, the prepared single crystal silicon substrate 3 is placed in a growth furnace in which the 3C-SiC single crystal film 5 is epitaxially grown, such as an RP-CVD apparatus (reduced pressure CVD apparatus), and the single crystal silicon substrate 3 is H₂-annealed under a hydrogen atmosphere to remove the natural oxide film on the surface (hydrogen baking step). This is because if the natural oxide film remains, the nucleation of SiC will be difficult when the 3C-SiC single crystal film 5 is epitaxially grown on the single crystal silicon substrate 3.

The H₂ annealing temperature condition at this time is preferably 1000°C or more and 1200°C or less. By setting the temperature to 1000°C or more, the hydrogen baking step to prevent the natural oxide film from remaining can be completed in a short time. Setting the temperature to 1200°C or less ensures that the occurrence of slip is suppressed. The pressure or time of the H₂ annealing at this time is not particularly limited as long as the natural oxide film is removed.

Next, as shown in FIG. 2(b), after the hydrogen baking step, a carbonization treatment is performed on the surface of the single crystal silicon substrate 3 to generate SiC nuclei, and then the 3C-SiC single crystal film 5 is hetero-epitaxially grown using the generated nuclei as starting points (epitaxial step).

Specifically, to first carbonize the surface of the single crystal silicon substrate 3 and form SiC nuclei, the temperature inside the apparatus is gradually increased from a temperature in the range of 300°C or more and 950°C or less to a temperature in the range of 1000°C or more and less than 1200°C while a carbonizing gas such as a propane gas is introduced into the RP-CVD apparatus as a raw material gas.

The raw material gas is then changed to a gas containing C and Si, such as trimethylsilane gas, and the 3C-SiC single crystal film 5 is epitaxially grown, starting from the nuclei generated by carbonization. The temperature increase rate during the epitaxial growth of SiC is preferably in the range of 0.5 to 5°C/min, and more preferably about 1°C/min.

Here, the thickness of the 3C-SiC single crystal film 5 grown in the epitaxial step may be thinner than the final target value. This is because the 3C-SiC single crystal film 5 is also grown in the subsequent step.

Next, as shown in FIG. 2(c), by heating the 3C-SiC single crystal epitaxial substrate to a temperature lower than the melting point of Si under a gas atmosphere containing carbon to cause solid state diffusion of Si in the single crystal silicon substrate 3 to the interface between the 3C-SiC single crystal film 5 and the single crystal silicon substrate 3, and further growing the SiC by solid phase reaction between the diffused Si and incoming C at the interface, the vacancy layer 7 having vacancies generated at sites from which Si has diffused, is formed at the interface with respect to the 3C-SiC single crystal film 5 in the single crystal silicon substrate 3 (diffusion step).

Specifically, for example, at a temperature of 1000°C or more and less than the melting point of silicon, while a gas containing C and Si, such as trimethylsilane gas, is introduced into the RP-CVD apparatus, the growth of the 3C-SiC single crystal film 5 is performed. At this time, the 3C-SiC single crystal film 5 is grown by gas phase reaction on the surface if the raw material contains not only C but also Si, but it is also grown by solid phase reaction between the carbon atoms which reach the interface between the 3C-SiC single crystal film 5 and the single crystal silicon substrate 3 and the Si which diffuses from the Si substrate to the interface.

Note that in the diffusion step, the solid phase reaction generates vacancies at sites from which Si has diffused out at the interface with respect to the 3C-SiC single crystal film 5 in the single crystal silicon substrate 3, to form the vacancy layer 7 containing the clusters of vacancies.

In this way, by using not only the gas phase reaction but also the solid phase reaction, it is also possible to grow SiC using the single crystal silicon substrate 3 as the Si source, and it is possible to produce the 3C-SiC single crystal epitaxial substrate 1 having the vacancy layer 7 in which vacancies exist at the interface with respect to the 3C-SiC single crystal film 5 in the single crystal silicon substrate 3, as shown in FIG. 1.

Note that it is preferable that the epitaxial step and the diffusion step are performed in a pressure range of 133.322 Pa (1 Torr.) or more and 13332.2 Pa (100 Torr.) or less. Specifically, it is preferable that the pressure in the RP-CVD apparatus at the epitaxial step and the diffusion step is set to 133.322 Pa or more and 13332.2 Pa or less.

By setting the pressure in the RP-CVD apparatus to 133.322 Pa or more, it is possible to perform the epitaxial step and the diffusion step without using a special decompression device. In addition, by setting the pressure in the RP-CVD apparatus to 13332.2 Pa or less, it is possible to promote the epitaxial growth of 3C-SiC in the epitaxial step and the diffusion of SiC in the diffusion step.

Note that, if the pressure in the RP-CVD apparatus during the diffusion step is set to about 666.612 Pa (5 Torr.), it is preferable because the growth of vacancies is promoted and the growth rate of SiC also increases. In addition, the time of the diffusion step is the time required to obtain a 3C-SiC single crystal film 5 and the vacancy layer 7 of the desired thickness.

The above is the description of the method for producing a 3C-SiC single crystal epitaxial substrate 1.

Next, by cooling the 3C-SiC single crystal epitaxial substrate 1 produced by this production method, the 3C-SiC single crystal epitaxial substrate 1 is divided along the vacancy layer 7, and the 3C-SiC single crystal film 5 is separated from the single crystal silicon substrate 3 to be the 3C-SiC free-standing substrate 9 (separation step), as shown in FIG. 2(d).

In the diffusion step, specifically, when the target 3C-SiC single crystal film 5 of the predetermined thickness is grown, the raw material gas supply is stopped and the temperature inside the RP-CVD apparatus is lowered, etc., to cool the 3C-SiC single crystal epitaxial substrate 1.

By lowering the temperature at this time, the 3C-SiC single crystal film 5 separates from the base 11 of the single crystal silicon substrate 3. In particular, when the temperature rapidly passes through the temperature range of about 400°C, the 3C-SiC single crystal epitaxial substrate 1 is rapidly divided along the vacancy layer 7 as the starting point, and the 3C-SiC single crystal film 5 is separated from the base 11 of the single crystal silicon substrate 3.

The specific treatment when lowering the temperature is not limited, as long as the 3C-SiC single crystal epitaxial substrate 1 can be divided to separate the 3C-SiC single crystal film 5 from the single crystal silicon substrate 3, but, for example, two treatments referred to as a cooling process and a low temperature treatment can be exemplified.

The cooling process is a treatment in which, after the target 3C-SiC single crystal film 5 of the predetermined thickness is grown, the 3C-SiC single crystal epitaxial substrate 1 is naturally cooled to 500°C, held at 500°C for 30 seconds to 3 minutes, and then cooled to 200°C at 4 to 5°C/min and taken out.

The low temperature treatment is a treatment in which, after the target 3C-SiC single crystal film 5 of the predetermined thickness is grown, the 3C-SiC single crystal epitaxial substrate 1 is directly placed in a furnace of 200°C, and after being treated at 200°C for 2 hours, the temperature is raised to 500°C at 4 to 5°C/min and held at 500°C for 30 seconds, and then it is taken out of the furnace and allowed to cool naturally at room temperature.

Here, even after being divided, the 3C-SiC single crystal film 5 is still on the base 11 of the single crystal silicon substrate 3, so it can be taken out of the RP-CVD apparatus as is, and after being taken out, the base 11 of the single crystal silicon substrate 3 and the 3C-SiC single crystal film 5 can be separated.

It is also possible to grow a 3C-SiC single crystal film 5 again by performing the baking step, the epitaxial step, and the diffusion step again, using the base 11 of the single crystal silicon substrate 3 after separation. At this time, as the base 11 of the single crystal silicon substrate 3, the surface after division may be used as is, or the surface may be polished, or cleaned, etc., once, depending on the size and density of the vacancies in the vacancy layer 7.

The above is the description of the method for producing a 3C-SiC free-standing substrate 9.

In this manner, by using an RP-CVD apparatus and the like as a growth apparatus capable of handling a large-diameter substrate, for example, the single crystal silicon substrate 3 having a diameter of 300 mm or more is subjected to the carbonization treatment after removing the natural oxide film from the surface in the hydrogen baking step, and then the hetero-epitaxial growth of the 3C-SiC single crystal film 5 on the single crystal silicon substrate 3 is performed, and the 3C-SiC single crystal film 5 is further grown by the solid state diffusion of the single crystal silicon substrate 3 by heating the single crystal silicon substrate 3 to a high temperature such that it does not melt and flowing a gas containing carbon, to produce the 3C-SiC epitaxial substrate having a lot of vacancies at the interface with respect to the 3C-SiC single crystal film 5 in the single crystal silicon substrate 3. By using these vacancies, the division can be performed by the subsequent cooling treatment and the like.

Therefore, in the production method of the 3C-SiC free-standing substrate 9 of the present invention, the 3C-SiC single crystal film 5 is hetero-epitaxially grown by using solid phase diffusion of the single crystal silicon substrate 3 as the Si source, and after forming the vacancy layer 7, the single crystal silicon substrate 3 is removed, thereby obtaining the 3C-SiC free-standing substrate 9 of large diameter such as 200 mm or 300 mm in diameter.

### EXAMPLE

Hereinafter, the present invention will be specifically described with reference to Example. However, the present invention is not limited thereto.

By the method for producing a 3C-SiC single crystal epitaxial substrate of the present invention, the 3C-SiC single crystal epitaxial substrate 1 was produced, and the 3C-SiC free-standing substrate 9 was further attempted to be produced. The specific procedure is as follows.

First, a low resistance single crystal silicon wafer doped with boron was prepared as a single crystal silicon substrate 3, with a diameter of 300 mm, a plane orientation of (111) of a surface, and a resistivity of 0.1 Ω·cm.

Next, the wafer was placed on a susceptor in a reaction furnace of an RP-CVD apparatus and H₂ annealing was performed at 1080°C for 1 minute as the hydrogen baking step. Then, as the epitaxial step, the temperature inside the furnace was lowered to 300°C, and then propane gas was introduced while the temperature was raised to 1130°C at a temperature increase rate of 1°C/sec to form SiC nuclei, and trimethylsilane gas was further introduced to perform the subsequent formation of 3C-SiC single crystal film 5. The growth pressure was set to a uniform 666.612 Pa (5 Torr) at this time.

Furthermore, after the temperature inside the reaction furnace reached 1130°C, it was held for 10 hours, and the diffusion step was performed to grow the 3C-SiC single crystal film 5 and form the vacancy layer 7. Then, when the film thickness of the 3C-SiC single crystal film 5 reached 100 µm, the raw material gas supply was stopped, and it was naturally cooled to 500°C, held at 500°C for 120 seconds, and cooled at 5°C/min to 200°C (cooling step) .

Then, the cooled 3C-SiC single crystal epitaxial substrate was taken out of the reaction furnace, and the crystal structure of the 3C-SiC single crystal epitaxial substrate was confirmed by XRD in an In-Plane arrangement as is without shifting the 3C-SiC single crystal film 5 and the single crystal silicon substrate 3. As shown in FIG. 3, the peak of 3C-SiC(220) parallel to Si(220) was confirmed, and it was confirmed that a single crystal 3C-SiC film was grown on the single crystal silicon substrate 3.

In addition, since the 3C-SiC single crystal epitaxial substrate 1 taken out of the reaction furnace could be separated into the 3C-SiC single crystal film 5 (3C-SiC free-standing substrate 9) and the base 11 of the single crystal silicon substrate 3 without performing any treatment of additional cooling and the like, it was also confirmed that it had already been divided in the cooling process before being taken out of the reaction furnace.

As described above, according to Example of the present invention, the 3C-SiC single crystal epitaxial substrate 1 could be produced, and the 3C-SiC free-standing substrate 9 could be produced by dividing the produced 3C-SiC single crystal epitaxial substrate 1.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A method for producing a 3C-SiC single crystal epitaxial substrate, the method comprising:
a hydrogen baking step of annealing a single crystal silicon substrate under a hydrogen atmosphere to remove a natural oxide film on a surface of the single crystal silicon substrate;
an epitaxial step of performing a carbonization treatment on the surface of the single crystal silicon substrate after the hydrogen baking step to generate SiC nuclei, and epitaxially growing a 3C-SiC single crystal film using the generated nuclei as starting points to obtain a 3C-SiC single crystal epitaxial substrate; and
a diffusion step of heating the 3C-SiC single crystal epitaxial substrate to a temperature lower than a melting point of Si under a gas atmosphere containing carbon to cause solid state diffusion of Si in the single crystal silicon substrate to an interface between the 3C-SiC single crystal film and the single crystal silicon substrate, and further growing the SiC by solid phase reaction between the diffused Si and incoming C at the interface, to form a vacancy layer having vacancies generated at sites from which Si has diffused, at the interface with respect to the 3C-SiC single crystal film in the single crystal silicon substrate.

2. The method for producing a 3C-SiC single crystal epitaxial substrate according to claim 1,
wherein the epitaxial step and the diffusion step are performed in a pressure range of 133.322 Pa or more and 13332.2 Pa or less.

3. A method for producing a 3C-SiC free-standing substrate, the method comprising a separation step of cooling the 3C-SiC single crystal epitaxial substrate produced by the method for producing a 3C-SiC single crystal epitaxial substrate according to claim 1 or 2 to divide the 3C-SiC single crystal epitaxial substrate along the vacancy layer, separating the 3C-SiC single crystal film from the single crystal silicon substrate, to be a 3C-SiC free-standing substrate.

4. A 3C-SiC single crystal epitaxial substrate comprising:
a single crystal silicon substrate; and
a 3C-SiC single crystal film having an epitaxial structure formed on the single crystal silicon substrate; wherein
the single crystal silicon substrate comprises a vacancy layer comprising clusters of vacancies generated due to loss of Si at an interface with respect to the 3C-SiC single crystal film.
